# EUROPEAN PATENT SPECIFICATION

(11) **EP 0 445 138 B1**
(45) Date of publication and mention of the grant of the patent: **26.03.1997**
(21) Application number: 89912574.4
(22) Date of filing: 03.11.1989
(51) Int. Cl.: H01L 39/12, C01F 1/00, C01F 17/00, C01G 3/02

(54) **PROCESS FOR PREPARING HOMOGENEOUS HIGH TEMPERATURE SUPERCONDUCTORS**
VERFAHREN ZUR HERSTELLUNG HOMOGENER HOCHTEMPERATURSUPRALEITER
PROCEDE DE FABRICATION DE SUPRACONDUCTEURS HOMOGENES A TEMPERATURE ELEVEE

(30) Priority: 28.11.1988 US 277000
(43) Date of publication of application: 11.09.1991
(73) Proprietor: E.I. DU PONT DE NEMOURS AND COMPANY, Wilmington Delaware 19898 (US)
(72) Inventor: LEARY, Kevin, J., Waverly, Tennessee 37185 (US)
(74) Representative: Jones, Alan John
(86) International application number: US8904813
(87) International publication number: WO9006598

(56) References cited:
- EP-A- 0 288 711
- MATERIALS RESEARCH SOCIETY SYMPOSIUM PROCEEDINGS, vol. 99, December 1987, Wang et al.: "YBa2 Cu3 O7-5 superconductors produced by hot-pressing of freeze-dried, carbonate- and oxalate-coprecipitated powders", pp. 257-260
- JAPANESE JOURNAL OF APPLIED PHYSICS LETTERS, vol. 27, no. 2, February 1988, Kumakura et al.: "Large magnetization in YBa2 Cu3 O7 prepared by sintering at high-temperature", pp. L188-L190
- MATERIALS RESEARCH SOCIETY SYMPOSIUM PROCEEDINGS, vol. 99, December 1987, Farneth et al.: "Kinetics and thermodynamics of the reaction of molecular oxygen with YBa2 Cu3 Ox", pp. 977-980
- NATURE, vol. 328, 27 August 1987, Matthews et al.: "Increased transition temperatures in YBa2 Cu3 O4 superconducting ceramics by exposure to nitrogen", pp. 786-787
- JOURNAL OF CHEMICAL SOCIETY, 1988, Mizuno et al.: "Reactions of the monoxides of carbon and nitrogen over superconducting lanthanoid mixed oxide YBa2 Cu3 O4", pp. 887-888
- PHYSICA STATUS SOLIDI (b) 142, K53; 1987, Herrmann et al.: "Preparation and properties of high Tc superconducting Y-Ba-Cu-O systems", pp. 53-56
- JAPANESE JOURNAL OF APPLIED PHYSICS LETTERS, vol. 26, no. 5, Nakai et al.: "X-ray single crystal structure analysis of tetregonal Ba2 Y Cu3 Oy, a high temperature form of the superconductor", pp. L788-L790
- JAPANESE JOURNAL OF APPLIED PHYSICS LETTERS, vol. 26, no. 5, Oda et al.: "Oxygen deficiency in YM2 Cu3 O7+y (M=Ba,Sr) family", pp. L804-L805

## Description

### BACKGROUND OF THE INVENTION

Bednorz and Muller, Z. Phys. B64, 189 (1986), disclose a superconducting phase in the La-Ba-Cu-O system with a superconducting transition temperature of about 35 K. This disclosure was subsequently confirmed by a number of investigators [see, for example, Rao and Ganguly, Current Science, 56, 47 (1987), Chu et al., Science 235, 567 (1987), Chu et al., Phys. Rev. Lett. 58, 405 (1987), Cava et al., Phys. Rev. Lett. 58, 408 (1987), Bednorz et al., Europhys. Lett. 3, 379 (1987)]. The superconducting phase has been identified as the composition La₁₋ₓ(Ba,sr,Ca)ₓO_{4-y} with the tetragonal K₂NiF₄-type structure and with x typically about 0.15 and y indicating oxygen vacancies.

Wu et al., Phys. Rev. Lett. 58, 908 (1987), disclose a superconducting phase in the Y-Ba-Cu-O system with a superconducting transition temperature of about 90 K. The compounds investigated were prepared with nominal compositions (Y₁₋ₓBaₓ)₂CUO_{4-y} and x = 0.4 by a solid-state reaction of appropriate amounts of Y₂O₃, BaCO₃ and CuO in a manner similar to that described in Chu et al., Phys. Rev. Lett. 58, 405 (1987). Said reaction method comprises heating the oxides in a reduced oxygen atmosphere of 2 Pa (2x10⁻⁵ bars) at 900°C for 6 hours. The reacted mixture is pulverized and the heating step is repeated. The thoroughly reacted mixture was then pressed into 3/16 inch (0.5 cm) diameter cylinders for final sintering at 925°C for 24 hours in the same reduced oxygen atmosphere. Cava et al., Phys. Rev. Lett. 58, 1676 (1987), have identified this superconducting Y-Ba-Cu-O phase to be orthorhombic, distorted, oxygen-deficient perovskite YBa₂Cu₃O_{9-δ} where δ is about 2.1 and present the powder x-ray diffraction pattern and lattice parameters.

Hundreds of other papers have since disclosed similar solid state reaction processes. Other papers have disclosed various solution and precipitation methods for preparing the reactants to be heated.

C. Michel et al., Z. Phys. B. - Condensed Matter 68, 421 (1987), disclose a novel family of superconducting oxides in the Bi-Sr-Cu-O system with composition close to Bi₂Sr₂Cu₂O_{7+δ}. A pure phase was isolated for the composition Bi₂Sr₂Cu₂O_{7+δ}. The X-ray diffraction pattern for this material exhibits some similarity with that of perovskite and the electron diffraction pattern shows the perovskite subcell with the orthorhombic cell parameters of a = 0.532 nm (5.32 Å), b = 2.66 nm (26.6 Å) and c = 4.88 nm (48.8 Å). The material made from ultrapure oxides has a superconducting transition with a midpoint of 22 K as determined from resistivity measurements and zero resistance below 14 K. The material made from commercial grade oxides has a superconducting transition with a midpoint of 7 K.

H. Maeda et al., Jpn. J. Appl. Phys. 27, L209 (1988), disclose a superconducting oxide in the Bi-Sr-Ca-Cu-O system with the composition near BiSrCaCu₂Ox and a superconducting transition temperature of about 105 K.

The commonly assigned application, "Superconducting Metal Oxide Compositions and Process For Making Them", S. N. 153,107, filed Feb. 8, 1988, a continuation-in-part of S. N. 152,186, filed Feb. 4, 1988, disclose superconducting compositions having the nominal formula BiₐSr_{b}Sa_{c}Cu₃Oₓ wherein a is from about 1 to about 3, b is from about 3/8 to about 4, c is from about 3/16 to about 2 and x = (1.5 a + b + c + y) where y is from about 2 to about 5, with the proviso that b + c is from about 3/2 to about 5, said compositions having superconducting transition temperatures of about 70 K or higher. It also discloses the superconducting metal oxide phase having the formula Bi₂Sr_{3-z}Ca_{z}Cu₂O_{8+w} wherein z is from about 0.1 to about 0.9, preferably 0.4 to 0.8 and w is greater than zero but less than about 1. M. A. Subramanian et al., Science 239, 1015 (1988) also disclose the Bi₂Sr_{3-z}Ca_{z}Cu₂O_{8+w} superconductor.

Z. Z. Sheng et al., Nature 332, 55 (1988) disclose superconductivity in the Tl-Ba-Cu-O system in samples which have nominal compositions Tl₂Ba₂Cu₃O₈₊ₓ and TlBaCu₃O_{5.5+x}. Both samples are reported to have onset temperatures above 90 K and zero resistance at 81 K. The samples were prepared by mixing and grinding appropriate amounts of BaCO₃ and CuO with an agate mortar and pestle. This mixture was heated in air at 925°C for more than 24 hours with several intermediate grindings to obtain a uniform black oxide Ba-Cu oxide powder which was mixed with an appropriate amount of Tl₂O₃, completely ground and pressed into a pellet with a diameter of 7 mm and a thickness of 1-2 mm. The pellet was then put into a tube furnace which had been heated to 880-910°C and was heated for 2-5 minutes in flowing oxygen. As soon as it had slightly melted, the sample was taken from the furnace and quenched in air to room temperature. It was noted by visual inspection that Tl₂O₃ had partially volatilized as black smoke, part had become a light yellow liquid, and part had reacted with Ba-Cu oxide forming a black, partially melted, porous material.

Z. Z. Sheng et al., Nature 332, 138 (1988) disclose superconductivity in the Tl-Ca-Ba-Cu-O system in samples which have nominal compositions Tl₂Ca₂BaCu₃O₉₊ₓ with onset of superconductivity at 120 K.

R. M. Hazen et al., Phys. Rev. Lett. 60, 1657 (1988), disclose two superconducting phases in the Tl-Ba-Ca-Cu-O system, Ti₂Ba₂Ca₂Cu₃O₁₀ and Tl₂Ba₂CaCu₂O₈, both with onset of superconductivity near 120 K. C. C. Torardi et al., Science 240, 631 (1988) disclose the preparation of Tl₂Ba₂Ca₂Cu₃O₁₀ with an onset of superconductivity of 125 K.

S. S. P. Parkin et al., Phys. Rev. Lett. 61, 750 (1988), disclose the structure TlBa₂Ca₂Cu₃O_{9±y} with transition temperatures up to 110 K.

M. Hervieu et al., J. Solid State Chem. 75, 212 (1988), disclose the oxide TlBa₂CaCu₂O_{8-y}.

C. C. Torardi et al., Phys. Rev. B 38, 225 (1988), disclose the oxide Tl₂Ba₂CuO₆ with an onset of superconductivity at about 90 K.

The commonly assigned application, "Superconducting Metal Oxide Compositions and Processes For Manufacture and Use", S. N. 236,088, filed Aug. 24, 1988, a continuation-in-part of S. N. 230,636, filed Aug. 10, 1988, disclose superconducting compositions having the nominal formula TlₑPbₐCa_{b}Sr_{c}Cu_{d}Oₓ wherein a is from about 1/10 to about 3/2, b is from about 1 to about 4, c is from about 1 to about 3, d is from about 1 to about 5, e is from about 3/10 to about 1 and x = (a + b + c + d + e +y) where y is from about 1/2 to about 3. These compositions have an onset of superconductivity of at least 70 K.

J. M. Liang et al., Appl. Phys. Lett. 53, 15 (1988) disclose a composition TlBa₂Ca₃Cu₄Oₓ with an onset of superconductivity at 155 K and a zero resistance at 123 K. CaCO₃, BaCO₃ and CuO powders were ground together and calcined for 15 hours with intermediate grindings. The Ba-Ca-Cu-O powders were mixed with Tl₂O₃ to yield a mixture with nominal composition TlBaCa₃Cu₃Oₓ. This mixture was ground, pressed and sintered for 15 minutes in flowing O₂. Composition ratios of the Tl:Ca:Ba:Cu in the superconductor vary from 1:2:2:3 to 1:2:3:4.

Marinenko et al., "Microbeam Analysis", Ed. D. E. Newbury, San Francico Press, San Francisco, CA (1988), p. 37, disclose the use of wavelength-dispersive X-ray compositional mapping to study YBa₂Cu₃O₆₊ₓ powders prepared by conventional solid state reaction techniques. Their elemental maps revealed a significant number of fairly large areas within the particles where the stoichiometry did not correspond to an atomic ratio of Y:Ba:Cu of 1:2:3. Moreover, in many cases, these regions were larger than the particle size of the original powders, indicating that these impurity phases were not the result of incomplete reaction, but instead were formed during processing.

### SUMMARY OF THE INVENTION

This invention provides a process for preparing homogeneous, substantially single phase high temperature copper-containing superconductor powders and sintered-powder articles.

It provides a process for improving the homogenety of MBa₂CU₃Oₓ, wherein M is at least one element chosen from Y, La, Nd, Sm, Eu, Gd, Dy, Ho, Er, Tm, Yb and Lu, and x is from about 6.5 to about 7.0, preferably from about 6.8 to about 7.0 comprised predominantly of slab-like particles.

This process and also a process for preparing homogeneous MBa₂Cu₃Oₓ, wherein M is at least one element chosen from Y, La, Nd, Sm, Eu, Gd, Dy, Ho, Er, Tm, Yb and Lu, and x is from about 6.5 to about 7.0, preferably from about 6.8 to about 7.0, comprises
(a) heating at least one starting material selected from MBa₂Cu₃Oₓ, MBa₂Cu₃O_{y} wherein y is from about 6.0 to about 6.5, and a mixture of M-, Ba-, and Cu-containing MBa₂Cu₃Oₓ precursors, said mixture having an M:Ba:Cu atomic ratio of about 1:2:3 in the presence of a an atmosphere containing an inert gas or a reaction gas and at least about 1% nitrogen dioxide at a temperature of from about 600°C to about 1000°C for at least about 1 hour,
(b) heating the product of step (a) in the presence of an oxygen-containing atmosphere at a temperature of from about 700°C to about 975°C for at least about one-half hour, and
(c) maintaining the product of step (b) in the presence of an oxygen-containing atmosphere while cooling for a time sufficient to obtain the MBa₂Cu₃Oₓ product.

Preferably, M is Y.

This invention also provides the product made by the above process.

### BRIEF DESCRIPTION OF THE DRAWING

Figure 1 is a plot of flux exclusion per unit mass of sample versus temperature for conventional YBa₂CU₃Oₓ powder, YBa₂CuOₓ powder subjected only to the heating in the nitrogen dioxide-containing atmosphere and the YBa₂CU₃Oₓ powder of the invention.

Figure 2 is a plot of resistance versus temperature for YBa₂CU₃Oₓ of the invention.

Figure 3a is a scanning electron micrograph of conventional YBa₂Cu₃Oₓ powder and Figure 3b is a scanning electron micrograph of YBa₂CU₃Oₓ powder of the invention.

Figure 4 is a plot of flux exclusion per unit mass of sample versus temperature for conventional YBa₂Cu₃Oₓ powder and for YBa₂CU₃Oₓ powders of the invention which were heated in a nitrogen dioxide-containing atmosphere at different temperatures.

Figure 5 is a plot of flux exclusion per unit mass of sample versus temperature for YBa₂CU₃Oₓ powders of the invention which were prepared from precursors and which were heated in a nitrogen dioxide-containing atmosphere at different temperatures.

### DETAILED DESCRIPTION OF THE INVENTION

The product of this invention is a homogeneous copper containing oxide superconductor with relatively uniform and well-defined morphology. The products of this invention exhibit a large increase in flux exclusion which indicates a large increase in the portion of the material which is superconducting. The particles of the powder products are predominantly within a relatively small range of size and are of well-defined morphology.

This invention provides a process for improving the homogeneity of and thereby the superconducting properties of high temperature metal oxide superconductors containing copper by heating them in a nitrogen dioxide-containing atmosphere and then heating and cooling them in an oxygen-containing atmosphere. The process of this invention can also be used to directly produce homogeneous high temperature metal oxide superconductors having improved properties from precursors of the metal oxide superconductors. In either instance, the sample used in the process can be in the form of a powder or of a shaped article such as a thin film, a thick film, a coating layer, tape, fiber, sintered pieces, etc.

In particular, this invention provides a process for improving the homogeneity of MBa₂Cu₃Oₓ or forming a homogeneous superconductor from non-superconducting tetragonal MBa₂Cu₃O_{y}. The MBa₂Cu₃Oₓ products of this invention exhibit a large increase in flux exclusion over that of the conventionally prepared MBa₂Cu₃Oₓ, the increase indicating a large increase in the portion of the material which is superconducting. Product powder has greatly improved slab-like morphology which may facilitate the processing of these powder particles.

The process of this invention can also be used to directly produce MBa₂Cu₃Oₓ superconductors having these improved properties from precursors of MBa₂Cu₃Oₓ.

The process of the invention comprises
(a) heating at least one starting material selected from the group consisting of MBa₂Cu₃Oₓ, MBa₂Cu₃O_{y} and stoichiometric mixtures of precursors of MBa₂Cu₃Oₓ in a nitrogen dioxide-containing atmosphere at temperatures of from about 600°C to about 1000°C for at least about 1 hour,
(b) heating the product of step (a) in an oxygen-containing atmosphere at a temperature of from about 700°C to about 975°C for at least about one-half hour, and
(c) maintaining the product of step (b) in an oxygen-containing atmosphere while cooling for a time sufficient to obtain the MBa₂Cu₃Oₓ product.

When the process of the invention is used to improve the homogeneity and superconducting properties of a sample of MBa₂Cu₃Oₓ or to produce homogeneous MBa₂Cu₃Oₓ from MBa₂Cu₃O_{y}, heating in a nitrogen dioxide-containing atmosphere is carried out at a temperature of from about 600°C to about 1000°C for about 1 hour or more. The temperature is preferably from about 900°C to about 975°C. Larger shaped articles may require longer heating times as well as longer annealing and cooling times.

When the process of the invention is used to produce homogeneous MBa₂Cu₃Oₓ directly from a mixture of precursors, the precursor mixture is comprised of compounds of M, Ba and Cu in amounts such that the atomic ratio of M:Ba:Cu is about 1:2:3. The mixture can be formed by simply mixing compounds such as M₂O₃, a barium source such as BaO₂, BaO, Ba(OH)₂, Ba(NO₃)₂ or BaCO₃ and CuO. Alternatively, the mixture can be formed by precipitation, spray drying or any of the other preparations known in the art. Heating in a nitrogen dioxide-containing atmosphere is carried out at a temperature of from about 600°C to about 1000°C for about 1 hour or more. The temperature is preferably from about 700°C to about 800°C.

The nitrogen dioxide-containing atmosphere can be pure nitrogen dioxide, a mixture of nitrogen dioxide and an inert gas such as argon or nitrogen, or a mixture of nitrogen dioxide and a reactant gas such as oxygen, said mixtures containing at least about 1% nitrogen dioxide. The inert gas serves as a carrier of the NO₂.

At the temperatures indicated some of the nitrogen dioxide, NO₂, may have dissociated and is present in the form of nitrogen oxide, NO. Reference herein to a "nitrogen dioxide-containing atmosphere" is meant to include the dissociation products such as nitrogen oxide.

It is believed that molten Ba(NO₃)₂ forms in the sample during this heating stage and acts as a flux which facilitates growth of highly pure material. The amount of Ba(NO₃)₂ that is formed depends on the composition of the nitrogen dioxide-containing atmosphere. Larger amounts of nitrogen dioxide in the atmosphere produce larger amounts of Ba(NO₃)₂ and result in finer-grained product whereas smaller amounts of nitrogen dioxide produce smaller amounts of Ba(NO₃)₂ and result in larger-grained material. For a given amount of nitrogen dioxide in the atmosphere, larger grains are obtained when a mixture of precursors is heated than when MBa₂Cu₃Oₓ is heated.

In the second step of the process of the invention, the sample which has been heated in the nitrogen dioxide-containing atmosphere is then heated in an oxygen-containing atmosphere at a temperature of from about 700°C to about 975°C for about 1/2 hour or more. The oxygen-containing atmosphere can be oxygen, air or a mixture of oxygen and an inert gas. Pure oxygen is preferred. Larger shaped articles may require longer times.

The sample is then cooled in an oxygen-containing atmosphere. During the cooling step, the oxygen content of the material increases to give the desired MBa₂Cu₃Oₓ product. The additional oxygen which enters into the crystalline lattice of the material during this cooling step to form the desired product does so by diffusion. The rate at which oyygen enters the lattice is determined by a complex function of time, temperature, oxygen content of atmosphere, sample form, etc. Consequently, there are numerous combinations of these conditions that will result in the desired product. For example, the rate of oxygen uptake at 400-500°C is rapid and the desired product can be obtained in an hour or less at these conditions when the sample has small dimensions.

Superconductivity can be confirmed by observing magnetic flux exclusion, i.e., the Meissner effect. This effect can be measured by the method described in an article by E. Polturak and B. Fisher in Physical Review B, 36, 5586(1987).

Superconductivity can also be confirmed by observing an absence of electrical resistivity. Resistance measurements can be carried out using the four probe technique.

Marinenko et al., "Microbeam Analysis", Ed. D. E. Newbury, San Francico Press, San Francisco, CA (1988), p. 37, disclose the use of wavelength-dispersive X-ray compositional mapping to study YBa₂Cu₃O₆₊ₓ powders prepared by conventional solid state reaction techniques. Their elemental maps revealed a significant number of fairly large areas within the particles where the stoichiometry did not correspond to an atomic ratio of Y:Ba:Cu of 1:2:3. Moreover, in many cases, these regions were larger than the particle size of the original powders, indicating that these impurity phases were not the result of incomplete reaction, but instead were formed during processing.

The lack of homogeneity in powders of YBa₂Cu₃Oₓ prepared using conventional solid state reactions as well as in samples obtained commercially has been confirmed by the present inventor using essentially the same techniques used by Marinenko et al. Four maps were obtained for each portion of sample observed. One was a digitalized scanning electromicrograph; the other three showed the concentration of yttrium, barium and copper, each in a different color. Superposition of the maps enabled the determination of particles or regions of particles that were (1) rich or deficient in the various elements or (2) homogeneous. In each of the conventionally-prepared or commercially-obtained samples, gross segregation was observed. Only samples prepared using the instant process showed an essentially uniform distribution of elements. "Homogeneous" is to be interpretted as the essentially uniform distribution measured in this manner. Powders prepared using the instant process showed, in addition to chemical homogeneity, a substantially homogeneous slab-like morphology.

The superconducting compositions of this invention can be used to conduct current extremely efficiently or to provide a magnetic field for magnetic imaging for medical purposes. Thus, by cooling the composition in the form of a wire or bar to a temperature below the superconducting transition temperature, (T_{c}), in a manner well known to those in this field; and initiating a flow of electrical current, one can obtain such flow without any electrical resistive losses. To provide exceptionally high magnetic fields with minimal power losses, the wire mentioned previously could be wound to form a coil which wouid be cooled to a temperature below the superconducting transition temperature before inducing any current into the coil. Such fields can be used to levitate objects as large as railroad cars. These superconducting compositions are also useful in Josephson devices such as SQUIDS (superconducting quantum interference devices) and in instruments that are based on the Josephson effect such as high speed sampling circuits and voltage standards.

The invention is illustrated by the following nonlimiting examples.

### EXAMPLE 1

Powder of nominal composition YBa₂CU₃Oₓ was prepared by thoroughly mechanically mixing 211.8 g Y₂O₃, 981.1 g Ba(NO₃)₂ and 447.6 g CuO, placing the mixture in an alumina tray which was placed in a furnace. The sample was heated under pure oxygen from room temperature to 970°C over a period of 2 hours, held at 970°C for 3 hours, cooled to 500°C over a period of about 3 hours, held at 500°C for 1 hour and then cooled in the furnace to room temperature. The material was then ground to a powder, passed through a 20 mesh screen (standard designation - 850 µm), heated again according to the above heating schedule, ground and passed through a 20 mesh screen. The resulting powder was typical of YBa₂CU₃Oₓ powder obtained using conventional solid state processes.

YBa₂Cu₃Oₓ powder (25 grams) was placed in an yttria-stabilized zirconia boat. The boat containing the powder was placed inside a quartz tube in the middle of a furnace. A mixture of about 50% nitrogen dioxide and 50% argon was passed over the sample at a rate of about 100 standard cubic centimeters per minute (sccm). The sample was heated from room temperature to 945°C over a period of 1.5 hours, held at 945°C for about 2 hours and then cooled to 350°C over a period of 3 hours. The NO₂/Argon stream was then turned off, and about 100 sccm of pure oxygen was passed over the sample while it was cooled from 350°C to room temperature over a period of about 5 hours. The sample was then removed from the furnace. During the heating in the nitrogen dioxide-containing atomsphere, the sample consolidated into a solid block in the shape of the boat. The sample was ground to a powder in a mortar and pestle. A portion of this powder was saved for analysis.

The rest of the ground powder was placed back in the boat and heated in flowing oxygen (about 100 sccm) from room temperature to 945°C over a period of 3 hours, held at 945°C for about 3 hours, cooled to 450°C over a period of 4 hours, cooled to 400°C over a period of 1 hour and then furnace cooled over a period of about 5 hours to room temperature. Following the heating and cooling in oxygen, the powder remained as a powder with only minimal consolidation. The powder was ground.

No significant differences were discernable in the X-ray diffraction powder patterns of the conventional and instant powders. However, the X-ray diffraction powder pattern for the powder subjected only to heating in the nitrogen dioxide-containing atmosphere indicates the presence of Ba(NO₃)₂. This is consistent with the observation that when the powder was being heated in O₂, NO₂ was observed in the reactor effluent when the powder was heated above 600°C.

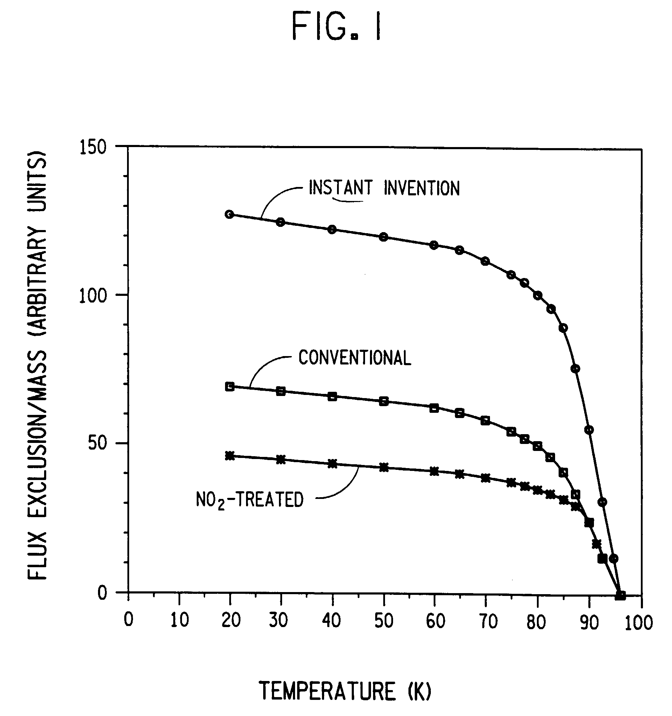

Comparative flux exclusion measurements were performed on the following: (1) YBa₂Cu₃Oₓ powder typical of that obtained using conventional solid state processes, (2) YBa₂Cu₃Oₓ powder subjected only to the heating in the nitrogen dioxide-containing atmosphere and not to the heating and cooling in an oxygen-containing atmosphere, and (3) YBa₂Cu₃Oₓ powder subjected to the heating in the nitrogen dioxide-containing atmosphere and the heating and cooling in an oxygen-containing atmosphere, i.e., the process of the invention. The results are shown in Figure 1. In each case, the curves were normalized by the mass of the sample used in the measurement. The curve for the powder made by the conventional process is indeed representative of that obtained from YBa₂Cu₃Oₓ powders made by such processes. Comparison of the flux exclusion per unit mass of sample vs. temperature curves for conventional powder and the powder that had been subjected to heating in the nitrogen dioxide-containing atmosphere reveals a decrease in the magnitude of the flux exclusion for the powder that had been subjected to heating in the nitrogen dioxide-containing atmosphere relative to the flux exclusion for the conventional powder. However, following the heating and cooling in an oxygen-containing atmosphere to produce the YBa₂Cu₃Oₓ powder of the invention, the instant powder exhibited a substantially larger flux exclusion than the conventional powder. Such a large increase in flux exclusion cannot be explained by particle size effects, since in each case, the particle size is much greater than the penetration depth for YBa₂Cu₃Oₓ. The superconducting transition for the instant powder is also significantly sharper, i.e., occurs over a narrower temperature range, than for the conventional powder. This large increase in flux exclusion and sharpening of the transition are two properties improved by the instant process.

### EXAMPLE 2

A 25 g portion of the conventional YBa₂Cu₃Oₓ powder prepared in Example 1 was subjected to essentially the same process of the invention described in Example 1, except that only a portion of the solid sample formed during the heating in the nitrogen dioxide-containing atmosphere was ground to a powder prior to the heating in oxygen. The other portion was retained as a solid piece. Both the solid piece and the powder were subjected to the heating and cooling in an oxygen-containing atmosphere essentially as described in Example 1.

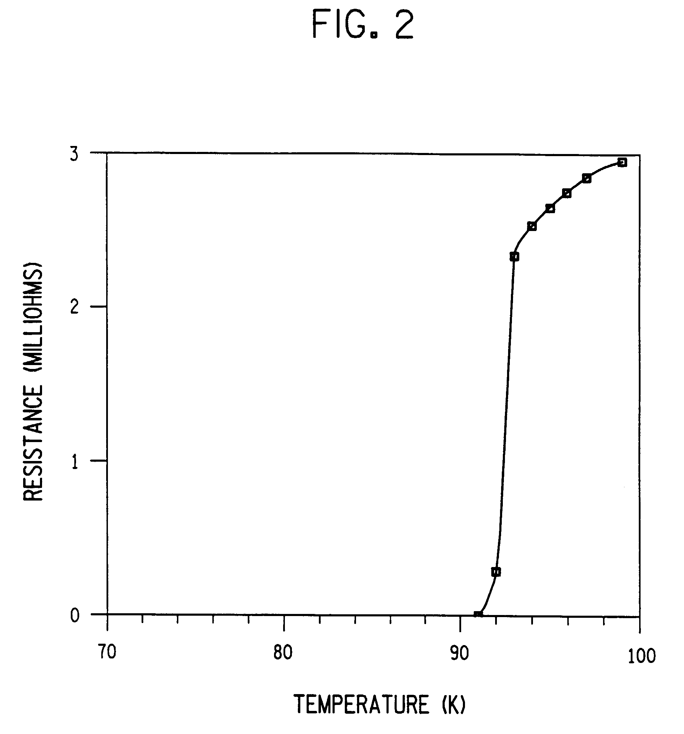

The solid piece was used for four-probe resistance measurements, the results of which are shown in Figure 2. Although this piece was not completely dense, it exhibited zero resistance at 91 K, and passed a critical current of about 30 A/cm² at 77 K with no applied magnetic field.

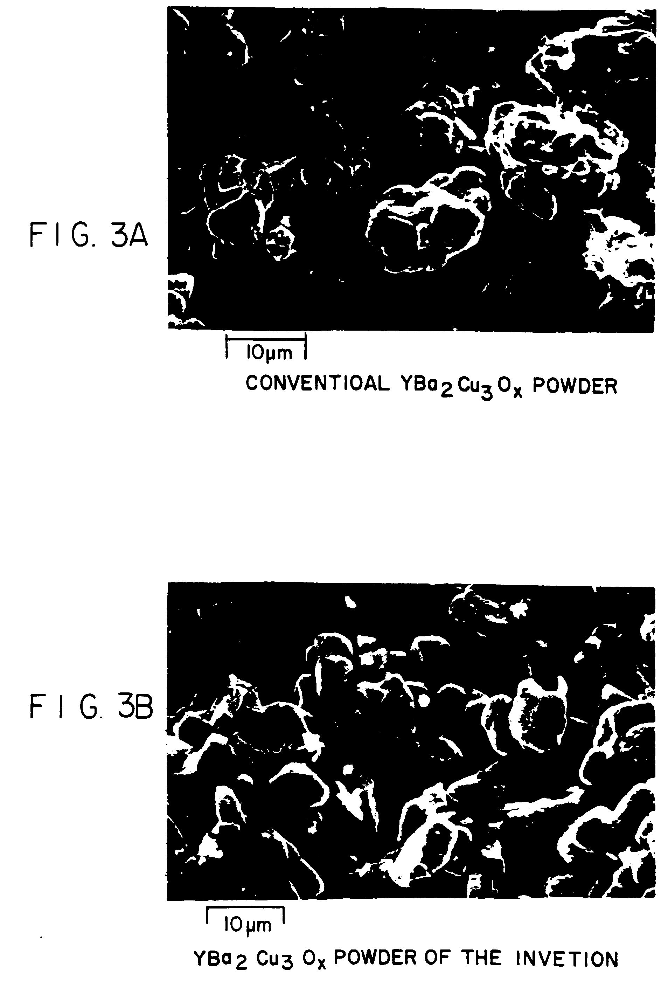

A scanning electron micrograph of conventional YBa₂Cu₃Oₓ powder is shown in Figure 3a. The micrograph of this powder reveals a variety of particle morphologies, ranging from semi-spherical particles to some poorly-defined slab-like particles. The micrograph also indicates the presence of small particles that may correspond to some impurity phases. A scanning electron micrograph of the powder after having undergone the process of the invention is shown in Figure 3b. The particle morphology changed dramatically. Virtually all of the particles appear slab-like, and the particle size increased. Moreover, the number of small impurity particles are less prevalent in the treated powder, and the grain boundaries are free of extraneous phases.

### EXAMPLES 3-7

These five Examples show the effect of the temperature used during the heating in the nitrogen dioxide-containing atmosphere. Five samples of conventional YBa₂Cu₃Oₓ powder prepared in Example 1 were subjected to the process of this invention essentially as described in Example 1 with the following exceptions. For the heating in the nitrogen dioxide-containing atmosphere, Example 1 was heated to and held at 945°C and Examples 3 - 7 were heated to and held at temperatures of 870°C, 895°C, 920°C, 945°C and 970°C respectively. Examples 4, 6 and 7 were not ground to a powder after heating in the nitrogen dioxide-containing atmosphere. Instead, following the 2 hour heating period in the nitrogen dioxide-containing atmosphere at the temperatures indicated directly above, the NO₂/argon stream was turned off, and pure oxygen was flowed over the sample (about 100 sccm) while the temperature was adjusted to 945°C. The samples were then held at 945°C in the oxygen flow for 3 hours, cooled to 450°C over a 4 hour period, cooled to 400°C over a period of 1 hour, and then furnace cooled to room temperature over a period of about 5 hours.

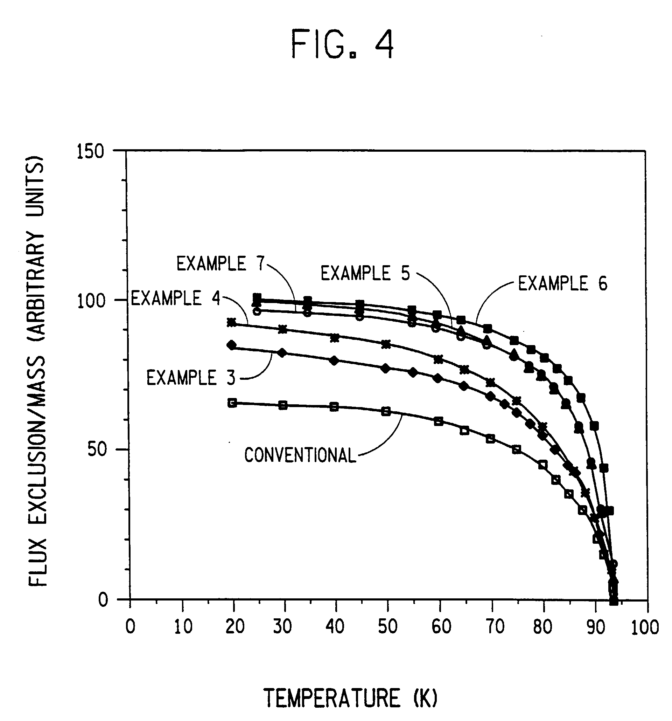

Flux exclusion measurements were carried out on all five examples and the results are shown in Figure 4. The flux exclusion for Examples 3 and 4 which were heated at 870°C and 895°C, respectively, show significant improvement over the conventional powder. The flux exclusions for Examples 5, 6 and 7 which were heated at 920°C, 945°C and 970°C showed the most improvement over the conventional powder and were quite similar. Example 6 exhibited a slightly sharper transition than the other powders.

Elemental maps of the variations in the yttrium, barium, and copper concentrations as a function of position as well as a map with the elemental maps superimposed (maps not shown in the Drawing) were obtained for the conventional powder, the powder of Example 3 and the powder of Example 6. Example 3 shows considerable improvement over the conventional powder regarding homogeneity. However, a significant degree of segregation remains. In contrast, Example 6 is essentially homogeneous throughout. The variations in homogeneity observed in the elemental maps correlate with the flux exclusion data shown in Figure 4, the greater the degree of homogeneity, the greater the flux exclusion.

### EXAMPLES 8-10

The effect of heating time in an oxygen-containing atmosphere was investigated in these three Examples. Three samples of conventional YBa₂Cu₃Oₓ powder prepared in Example 1 were subjected to the process of this invention essentially as described in Example 6 except that for Examples 9 and 10 the time for which the sample was held at 945°C in oxygen was 1 hour and 5 hours, respectively, rather than 3 hours as for Example 6. Example 8 is essentially identical to Example 6 and the time for which the sample was held at 945°C in oxygen was 3 hours. The flux exclusion curves for the three powders produced in Examples 8 - 10 are essentially identical and are not sensitive to the oxygen heating times.

### EXAMPLES 11-13

The effect of heating temperature in an oxygen-containing atmosphere was investigated in these three Examples. Three samples of conventional YBa₂Cu₃Oₓ powder prepared in Example 1 were subjected to the process of this invention essentially as described in Example 6 except that the temperature to which the samples were heated and held in the nitrogen-containing atmosphere was 920°C rather than 945°C and the temperatures at which the samples were heated in an oxygen-containing atmosphere for 3 hours were 770°C and 870°C respectively for Examples 11 and 12. The corresponding temperature used in Example 13 was 945°C as used in Example 6. The flux exclusion curves for the three powders produced in Examples 11 - 13 are essentially identical and are not sensitive to the oxygen heating temperatures.

### EXAMPLE 14

Conventional YBa₂Cu₃Oₓ powder was prepared using essentially the process described in Example 1.

YBa₂Cu₃Oₓ powder (10 grams) was placed in an yttria-stabilized zirconia boat. The boat containing the powder was placed inside a quartz tube in the middle of a furnace. A mixture of about 50% nitrogen dioxide and 50% oxygen was passed over the sample at a rate of about 100 standard cubic centimeters per minute (sccm). The sample was heated from room temperature to 950°C over a period of 1.5 hours and held at 950°C for about 2 hours. With the temperature maintained at 945°C, the gas stream was gradually changed to pure oxygen over a period of about 1 hour and the temperature was then held at 950°C for 2 hours. The sample was then cooled to 450°C over a period of 4 hours, cooled to 400°C over a period of 1 hour and then furnace cooled over a period of about 5 hours to room temperature.

Flux exclusion measurements were made and the flux exclusion curve obtained is similar to that obtained when argon is used as a carrier gas for the nitrogen dioxide.

### EXAMPLES 15-17

In this Example, YBa₂Cu₃Oₓ powder with improved properties was produced directly from precursors of YBa₂Cu₃Oₓ.

Precursor powder (10 grams) comprised of an intimate mixture of Y₂O₃, BaCO₃, and CuO with the atomic ratio of Y:Ba:Cu of 1:2:3 was placed in an alumina boat and placed in a furnace. A mixture of about 50% nitrogen dioxide and 50% oxygen was passed over the sample at a rate of about 100 standard cubic centimeters per minute (sccm). The powder was heated over a 90 minute period to a temperature of 750°C, 850°C and 950°C, respectively, for Examples 15, 16 and 17 and then held at that temperature for 2 hours. The gas was then switched to pure oxgyen over a 1 hour period while the temperature was adjusted to 950°C and the temperature was then held at 950°C for 2 hours. The sample was then cooled to 450°C over a period of 4 hours, cooled to 400°C over a period of 1 hour and then furnace cooled over a period of about 5 hours to room temperature.

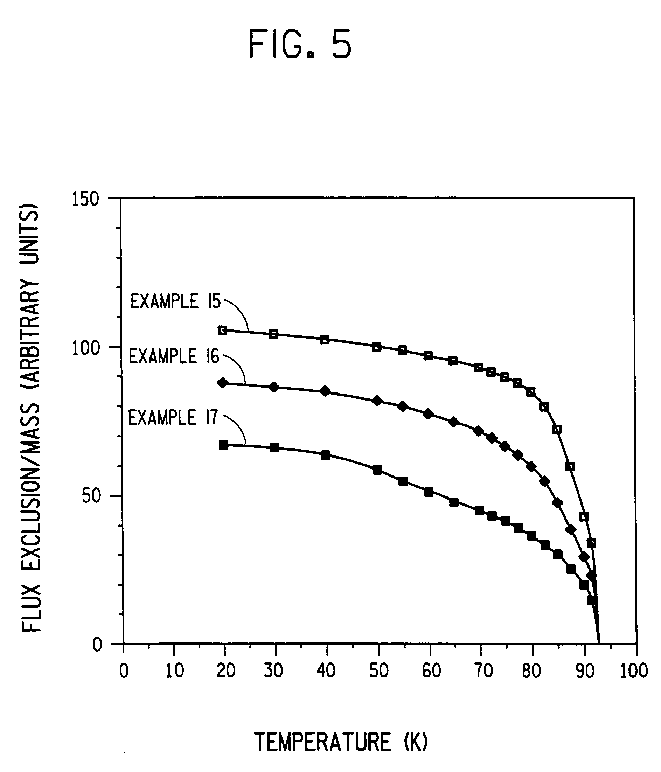

Flux exclusion measurements were carried out and the results are shown in Figure 5. The powder heated in the nitrogen dioxide-containing atmosphere at 750°C has higher flux exclusion than those heated at 850°C or 950°C.

## Claims

1. Process for improving the homogeneity of MBa₂Cu₃Oₓ or for preparing homogeneous superconducting MBa₂Cu₃Oₓ, wherein M is at least one element chosen from Y, La, Nd, Sm, Eu, Gd, Dy, Ho, Er, Tm, Yb and Lu, and x is from about 6.5 to about 7.0, said process comprising:
(a) heating at least one starting material selected from MBa₂Cu₃Oₓ, MBa₂Cu₃O_{y} wherein y is from about 6.0 to about 6.5, and a mixture of M-, Ba- and Cu-containing MBa₂Cu₃Oₓ precursors, said mixture having an M:Ba:Cu atomic ratio of about 1:2:3, in the presence of an atmosphere containing an inert gas or a reaction gas and at least about 1% nitrogen dioxide at a temperature of from about 600°C to about 1000°C for at least about one hour;
(b) heating the product of step (a) in the presence of an oxygen-containing atmosphere at a temperature of from about 700°C to about 975°C for at least about one-half hour; and
(c) maintaining the product of step (b) in the presence of an oxygen-containing atmosphere while cooling for a time sufficient to obtain said MBa₂Cu₃Oₓ.

2. Process of Claim 1 wherein the starting material is MBa₂Cu₃Oₓ or MBa₂Cu₃O_{y}.

3. Process of Claim 2 wherein the temperature of step (a) is from about 700°C to about 1000°C.

4. Process of Claim 3 wherein the temperature is from about 900°C to about 975°C.

5. Process of Claim 1 wherein the starting material is a mixture of M-, Ba-, and Cu-containing MBa₂Cu₃Oₓ precursors in an M:Ba:Cu atomic ratio of about 1:2:3.

6. Process of Claim 5 wherein the temperature of step (a) is from about 600°C to about 900°C.

7. Process of Claim 6 wherein the temperature is from about 700°C to about 800°C.

8. Process of Claim 1 wherein M is Y.

## Patentansprüche

1. Verfahren zur Verbesserung der Homogenität von MBa₂Cu₃Oₓ oder zur Herstellung von homogenem supraleitendem MBa₂Cu₃Oₓ, wobei M wenigstens ein Element ist, das aus Y, La, Nd, Sm, Eu, Gd, Dy, Ho, Er, Tm, Yb und Lu ausgewählt ist, und x etwa 6,5 bis etwa 7,0 beträgt, wobei das Verfahren umfaßt:
(a) das Erhitzen wenigstens eines Ausgangsstoffes, der aus MBa₂Cu₃Oₓ, MBa₂Cu₃O_{y}, wobei y etwa 6,0 bis etwa 6,5 beträgt, und einem Gemisch von M-, Ba- und Cu-haltigen MBa₂Cu₃Oₓ-Vorstufen ausgewählt ist, wobei das Gemisch ein M:Ba:Cu-Atomverhältnis von etwa 1:2:3 aufweist, in Gegenwart einer Atmosphäre, die ein Inertgas oder ein Reaktionsgas und wenigstens etwa 1% Stickstoffdioxid enthält, bei einer Temperatur von etwa 600°C bis etwa 1000°C während wenigstens etwa einer Stunde;
(b) Erhitzen des Produkts von Schritt (a) in Gegenwart einer sauerstoffhaltigen Atmosphäre bei einer Temperatur von etwa 700°C bis etwa 975°C während wenigstens etwa einer halben Stunde; und
(c) Belassen des Produkts von Schritt (b) in Gegenwart einer sauerstoffhaltigen Atmosphäre während des Abkühlens während einer Zeit, die ausreicht, um das MBa₂Cu₃O_{X} zu erhalten.

2. Verfahren gemäß Anspruch 1, wobei es sich bei dem Ausgangsstoff um MBa₂Cu₃Oₓ oder MBa₂Cu₃O_{y} handelt.

3. Verfahren gemäß Anspruch 2, wobei die Temperatur von Schritt (a) etwa 700°C bis etwa 1000°C beträgt.

4. Verfahren gemäß Anspruch 3, wobei die Temperatur etwa 900°C bis etwa 975°C beträgt.

5. Verfahren gemäß Anspruch 1, wobei es sich bei dem Ausgangsstoff um ein Gemisch von M-, Ba- und Cu-haltigen MBa₂Cu₃Oₓ-Vorstufen in einem M:Ba:Cu-Atomverhältnis von etwa 1:2:3 handelt.

6. Verfahren gemäß Anspruch 5, wobei die Temperatur von Schritt (a) etwa 600°C bis etwa 900°C beträgt.

7. Verfahren gemäß Anspruch 6, wobei die Temperatur etwa 700°C bis etwa 800°C beträgt.

8. Verfahren gemäß Anspruch 1, wobei es sich bei M um Y handelt.

## Revendications

1. Procédé pour améliorer l'homogénéité de MBa₂Cu₃Oₓ ou pour préparer un MBa₂Cu₃Oₓ supraconducteur homogène, dans lequel M est au moins un élément choisi parmi Y, La, Nd, Sm, Eu, Gd, Dy, Ho, Er, Tm, Yb et Lu, et x est d'environ 6,5 à environ 7,0, ledit procédé comprenant :
(a) le chauffage d'au moins une matière de départ choisie parmi MBa₂Cu₃Oₓ, MBa₂Cu₃O_{y} où y est d'environ 6 à environ 6,5, et un mélange de précurseurs de MBa₂Cu₃Oₓ contenant M, Ba et Cu, ledit mélange ayant un rapport atomique M:Ba:Cu d'environ 1:2:3, en présence d'une atmosphère contenant un gaz inerte ou un gaz de réaction et au moins environ 1 % de peroxyde d'azote, à une température d'environ 600°C à environ 1000°C pendant au moins environ une heure ;
(b) le chauffage du produit de l'étape (a) en présence d'une atmosphère contenant de l'oxygène, à une température d'environ 700°C à environ 975°C pendant au moins environ une demi-heure ; et
(c) le maintien du produit de l'étape (b) en présence d'une atmosphère contenant de l'oxygène tout en refroidissant pendant un temps suffisant pour obtenir ledit MBa₂Cu₃Oₓ.

2. Procédé selon la revendication 1, dans lequel la matière de départ est MBa₂Cu₃Oₓ ou MBa₂Cu₃O_{y}.

3. Procédé selon la revendication 2, dans lequel la température de l'étape (a) est d'environ 700°C à environ 1000°C.

4. Procédé selon la revendication 3, dans lequel la température est d'environ 900°C à environ 975°C.

5. Procédé selon la revendication 1, dans lequel la matière de départ est un mélange de précurseurs de MBa₂Cu₃Oₓ contenant M, Ba et Cu dans un rapport atomique M:Ba:Cu d'environ 1:2:3.

6. Procédé selon la revendication 5, dans lequel la température de l'étape (a) est d'environ 600°C à environ 900°C.

7. Procédé selon la revendication 6, dans lequel la température est d'environ 700°C à environ 800°C.

8. Procédé selon la revendication 1, dans lequel M est Y.
